# EUROPÄISCHE PATENTSCHRIFT

(11) **EP 1 170 793 B1**
(45) Veröffentlichungstag und Bekanntmachung des Hinweises auf die Patenterteilung: **21.11.2007**
(21) Anmeldenummer: 01114597.6
(22) Anmeldetag: 18.06.2001
(51) Int. Cl.: H01L 23/31, H01L 23/495, H01L 23/13

(54) **Trägermatrix mit Bondkanal für integrierte Halbleiter und Verfahren zu ihrer Herstellung**
Support matrix with a bonding channel for an integrated circuit and manufacturing method thereof
Matrice porteuse avec une zone de connexion pour un circuit intégré et procédé pour sa fabrication

(30) Priorität: 07.07.2000 DE 10034006
(43) Veröffentlichungstag der Anmeldung: 09.01.2002
(73) Patentinhaber: Infineon Technologies AG, 81669 München (DE)
(72) Erfinder: Kahlisch, Knut, 01109 Dresden (DE); Mieth, Henning, 09387 Jahnsdorf (DE)
(74) Vertreter: Epping - Hermann - Fischer

(56) Entgegenhaltungen:
- US-A- 6 013 946
- PATENT ABSTRACTS OF JAPAN vol. 1999, no. 04, 30. April 1999 (1999-04-30) -& JP 11 008275 A (NEC CORP), 12. Januar 1999 (1999-01-12)
- PATENT ABSTRACTS OF JAPAN vol. 018, no. 336 (E-1568), 24. Juni 1994 (1994-06-24) -& JP 06 085111 A (HITACHI LTD;OTHERS: 01), 25. März 1994 (1994-03-25)
- PATENT ABSTRACTS OF JAPAN vol. 1999, no. 04, 30. April 1999 (1999-04-30) -& JP 11 017048 A (SAMSUNG ELECTRON CO LTD), 22. Januar 1999 (1999-01-22)
- PATENT ABSTRACTS OF JAPAN vol. 1996, no. 11, 29. November 1996 (1996-11-29) -& JP 08 186191 A (MATSUSHITA ELECTRIC WORKS LTD), 16. Juli 1996 (1996-07-16)
- PATENT ABSTRACTS OF JAPAN vol. 1997, no. 03, 31. März 1997 (1997-03-31) -& JP 08 293626 A (OMRON CORP), 5. November 1996 (1996-11-05)

## Beschreibung

Die Erfindung betrifft eine Trägermatrix mit Bondkanal für integrierte Halbleiter mit einer Barriere am Bondkanal und ein Verfahren zur Herstellung einer solchen Trägermatrix.

Moderne Miniaturgehäuse für integrierte Halbleiter wie µBGA, FBGA etc. bestehen neben der eigentlichen Ummantelung und dem Siliziumchip aus einer Trägermatrix. Diese Trägermatrix dient der Stabilisierung und der elektrischen Verbindung der Kontaktflächen des Halbleiterchips mit den Außenkontakten des Gehäuses. Zu diesem Zweck weist die Trägermatrix einen Rahmen, beispielsweise eine geeignet ausgeformte Polyimidfolie von beispielsweise 50 µm Dicke auf sowie eine Leiterbahnstruktur, welche die Kontaktflächen miteinander verbindet. Zumeist wird der Halbleiterchip mit einer Seite der Trägermatrix verbunden, während auf der anderen Seite der Trägermatrix Kontakte zur Außenanbindung des Gehäuses auf einer Platine o.ä. angeordnet sind. Die Leiterbahnstruktur wird zumeist auf der Seite des Rahmens angeordnet, auf der auch:der Halbleiterchip zu liegen kommt, während die Außenkontakte auf der anderen Seite liegen. Die Verbindung zwischen den Leiterbahnstrukturen und den Außenkontakten wird durch Löcher im Rahmen erreicht.

Die eigentliche Verbindung zwischen Leiterbahnstrukturen und dem Halbleiterchip erfolgt über sogenannte Bondleads, das heißt zungenförmige Bereiche an der Leiterbahnstruktur, die zum Halbleiterchip hin gebogen sind oder gebogen werden können, um mit den Kontaktflächen des Halbleiterchips in Kontakt zu treten, oder vermittels von Golddrähten. Die Bondleads werden dann an den Halbleiter gebondet, beispielsweise durch Schweißen, Mikroschweißverfahren oder Löten.

Bei einer üblichen Vorgehensweise werden die Bondleads in einem sogenannten Bondkanal konzentriert. Dieser Bondkanal ist eine Öffnung im Rahmen, welche von der Halbleiterchip-abgewandten Seite einen Zugang zu den Bondleads bzw. die Verdrahtung ermöglicht. Bei der Montage der Trägermatrix an den Halbleiterchip werden von der Halbleiterchip-abgewandten Seite der Trägermatrix mittels Bondstempeln die Bondleads zum Halbleiterchip hin gedrückt und dort gebondet oder es werden Golddrähte von der Leiterbahnstruktur zum Helbleiter gebondet.

Die Bondleads sind über einen sogenannten Anker mit dem Rest der Leiterbahnstrukturen verbunden. Auf der dem Anker gegenüberliegenden Seite befindet sich häufig ein Gegenanker, der über eine Sollbruchstelle mit dem eigentlichen Bondbereich des Bondleads verbunden ist. Beim Anpressen des Bondbereichs an die Kontaktstelle des Halbleiterchips reißt die Sollbruchstelle.

Zur Stabilisierung der Verbindung zwischen Trägermatrix und Halbleiterchip werden die Bondkanäle mit einem geeigneten Material ausgefüllt.

Dieses Füllmaterial ist größtenteils ein niederviskoses, dispensfähiges Material. Damit besteht die Gefahr, dass Flächen der Trägermatrix von diesem Material kontaminiert werden, die für nachfolgende Prozeßschritte bei der Herstellung des Chips unbedingt sauber bleiben müssen.

Bisher wurden in einem zeit- und kostenintensiven Verfahren, u.a. in einem mehrstufigen Dispensverfahren, dem sog. Dam & Fill, mehrere Materialien verschiedener Viskosität dergestalt aufgebracht, dass mittels eines Rahmens das Austreten des niederviskosen Materials verhindert wurde. Eine zuverlässige, von Verunreinigungen geschützte, dem Bondkanal benachbarte Fläche konnte so jedoch nicht in allen Fällen erreicht werden. Insbesondere bei dicht angrenzenden, aktiven Zonen ist ein dispenster Rahmen nicht realisierbar.

Aus JP 11 008275 A ist eine Trägermatrix nach dem Oberbegriff des Anspruchs 1 bekannt. Ferner ist aus US 6,013,946 eine Trägermatrix mit einer als Rille ausgebildeten Barriere bekannnt, die das Fließen eines flußfähigen Materials erschwert.

Es ist demgegenüber die Aufgabe der vorliegenden Erfindung, Maßnahmen bereitzustellen, welche ein Kriechen von flussfähigem Material aus dem Bondkanal noch zuverlässiger verhindern können.

Diese Aufgabe wird gelöst durch die Bereitstellung einer Trägermatrix für integrierte Halbleiterchip gemäß dem unabhängigen Patentanspruch 1 sowie Verfahren zur Herstellung einer solchen Trägermatrix gemäß dem unabhängigen Patentanspruch 6.

Die Erfindung ist zunächst gerichtet auf eine Trägermatrix für integrierte Halbleiter mit einem Rahmen, Leiterbahnstrukturen und zumindest einem Bondkanal, in dem Bondleads oder Drähte zur Verbindung der Leiterbahnstrukturen mit dem integrierten Halbleiter angeordnet sind, wobei am Rand des Bondkanals eine Barriere zur Verhinderung des Fliessens von flussfähigem Material aus dem Bondkanal auf den Rahmen und/oder die Leiterbahnstrukturen angeordnet ist.

Der erfinderische Grundgedanke liegt somit darin, statt aufwendige Reinigungs- oder Abdichtungsmaßnahmen durchzuführen, durch eine am Rand des Bondkanals angeordnete Barriere, die mit einem Trennmittel versehen ist, das Kriechen des für verwendeten Materials in den zu schützenden Bereich zu verhindern.

Die Barriere stellt eine Trennlinie für das flussfähige Material zwischen den Leiterbahnen und dem Rahmen einerseits und dem Bondkanal andererseits dar. Die Barriere ist günstigerweise so orientiert, dass sie quer zur möglichen Flussrichtung des Silikonmaterials um den gesamten Bondkanal herumführt. Zumindest wird es bevorzugt, dass die Seiten des Bondkanals, die neben besonders sensiblen Bereichen der Trägermatrix liegen, mit einer erfindungsgemäßen Barriere versehen werden.

Erfindungsgemäß weist die Barriere einen Bereich mit einem Trennmittel auf, welches das flussfähige Material abweist. Hier wird also das Adhäsionsvermögen des flussfähigen Materials auf dem Untergrund durch die Verwendung einer Beschichtung so verändert, dass es nicht in der Lage ist, über den beschichteten Bereich hinweg auf den zu schützenden Bereich zu .kriechen.

Vorzugsweise ist die zumindest eine Barriere an allen Seiten des Bondkanals angeordnet und umgibt diesen vollständig.

Je nach geplanter Funktion kann die Barriere unterschiedlich angeordnet sein. So kann die zumindest eine Barriere auf dem Rahmen und/oder auf den Bondleads und/oder auf den Leiterbahnstrukturen angeordnet sein. Die genaue Konfiguration der Barriere ist vom gewünschten Verwendungszweck und den an der Stelle der Barriere gegebenen Verhältnissen abhängig. Sie kann näher am Rand des Bondkanals angeordnet sein und beispielsweise über Ankerbereiche der Bondleads hinweggeführt sein; oder weiter davon entfernt und dann über Leiterbahnen und den eigentlichen Rahmen hinweggeführt sein. In Bereichen, welche vollständig von Leiterbahnstrukturen bedeckt sind, wird die Barriere ggfs. nur über diese geführt werden, während eine Barriere in einem Bereich der Trägermatrix ohne Leiterbahnen nur über den Rahmen hinweggeführt werden könnte.

Die zumindest eine Barriere kann auch auf der den Bondleads abgewandten Oberfläche des Rahmens angeordnet sein. Dies ermöglicht einen Schutz der Halbleiterchip-abgewandten Seite der Trägermatrix, beispielsweise um eine Kontamination der externen Kontaktflächen zu vermeiden. Es ist auch möglich, Barrieren auf beiden Seiten der Trägermatrix anzuordnen, die übereinander oder auch seitlich gegeneinander versetzt sein können, um beispielsweise bei dünnen Trägermatrizen eine hinreichende Tiefe der Barriere, wenn diese als Rille ausgebildet ist, zu ermöglichen.

Das flussfähige Material kann beispielweise Silikon zur Ausbildung von Strukturen auf der Trägermatrix sein.

Die Barriere weist eine Rille auf. Bei Verwendung einer Rille macht man sich den Kanteneffekt für Fluss und Adhäsion von flussfähigem Material zu Nutze, bei dem ein flussfähiges Material nicht in der Lage ist, um eine abwärts gerichtete Kante herum zu fließen. Auf diese Weise kann eine Rille eine wirksame Barriere für Flüssigkeiten darstellen. Auch die Verwendung eines Walls, das heißt vorspringenden Barriereelements, kann einen begrenzenden Effekt haben, der abhängig ist von den Adhäsionseigenschaften des flussfähigen Materials auf dem jeweiligen Untergrund.

Es ist möglich, verschiedene Arten der oben angesprochenen Barrieren miteinander zu kombinieren oder mehrere gleichartige Barrieren hintereinander auf dem Bondlead anzuordnen. Solche Maßnahmen können, wenn auch bei erhöhtem Aufwand, die Rückhaltewirkung der erfindungsgemäßen Barriere weiter verbessern.

Weiterhin ist die Erfindung auf ein Verfahren zur Herstellung einer Trägermatrix für integrierte Halbleiter mit einem Rahmen, Leiterbahnstrukturen und zumindest einem Bondkanal gerichtet, in dem Bondleads zur Verbindung der Leiterbahnstrukturen mit dem integrierten Halbleiter angeordnet sind, dass folgenden Schritt aufweist: - Einarbeiten zumindest einer Rille am Rand des Bondkanals zur Verhinderung des Fließens von flussfähigem Material aus dem Bondkanal auf den Rahmen und/oder auf die Leiterbahnstrukturen sowie Aufbringen eines Trennmittels, welches das flußfähige Material abweist, auf einen Bereich der Rille.

Hierbei kann das erfindungsgemäße Verfahren vorzugsweise photochemisch erfolgen und die folgenden Schritte aufweisen:
- Aufbringen einer Lackmaske; und
- Ätzen von Querrillen in den Anker des Bondleads.

Das Aufbringen der Lackmaske erfolgt z.B. in dem Fachmann geläufiger Weise durch Beschichten mit einem Photolack, Aufbelichten des gewünschten Musters und Entwickeln der Lackschicht.

Alternativ kann das Verfahren folgenden Schritt aufweisen:
- Prägen von Querrillen in den Anker des Bondleads. Um den Barriereeffekt zu verstärken, kann es bevorzugt sein, mehrere parallel verlaufende Barrieren hintereinander zu schalten.

Die Ätztiefe bzw. Prägetiefe sollte so bemessen sein, dass einerseits ein Überfließen verhindert wird, andererseits kein zusätzlicher Flächenbedarf notwendig wird.

Die Herstellung der Barrieren kann bei der integrierten Herstellung der Leiterbahnstrukturen und Bondleads und vor ihrer Verbindung mit dem Rahmen der Trägermatrix erfolgen. Alternativ ist es auch möglich, die Barrieren nach der Verbindung von Rahmen und Leiterbahnstruktur/Bondleadschicht anzubringen.

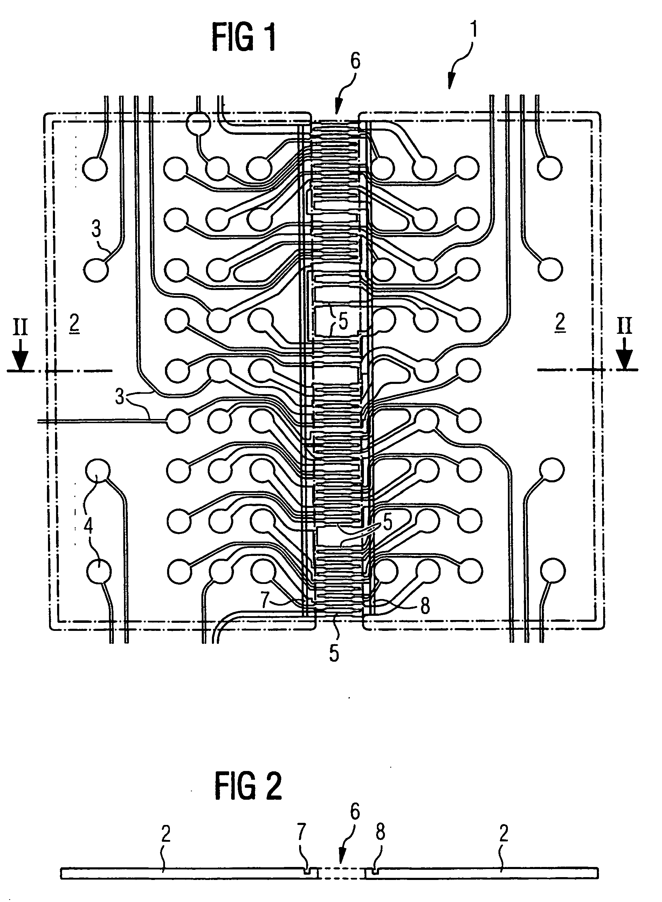

Im folgenden wird unter Bezugnahme auf Figuren 1 und 2 ein Ausführungsbeispiel der vorliegenden Erfindung erläutert.

Figur 1 zeigt in Aufsicht einen Bereich einer Trägermatrix 1 als beispielhafte Auführungsform der vorliegenden Erfindung. Auf einem Rahmen 2 sind Leiterbahnstrukturen ausgebildet, die aus Leiterbahnen 3 und externen Kontaktflächen 4 zur Kontaktierung des Gehäuses mit Schaltungen, beispielsweise auf Platinen, bestehen. Die Bondleads 5 sind in einem Bondkanal 6 konzentriert. Sie bestehen aus einem Anker, einem Gegenanker und dem zentralen, eigentlichen Bondbereich zur Verbindung eines Bondleads mit dem Halbleiterchip.

Die erfindungsgemäßen Barrieren 7, 8 sind längs des Bondkanals an seinem Rand angeordnet. Wie aus Fig. 2 ersichtlich, verlaufen sie über die gesamte Längsseite des dargestellten Bondkanals 6 und somit über die Leiterbahnstrukturen und den eigentlichen Rahmen 2.

Figur 2 ist ein Querschnitt durch die Trägermatrix der Figur 1 längs der Schnittlinie II-II. Die Barrieren 7 und 8, welche am Rand des Bondkanals 6 entlanglaufen, sind hier als Rillen gezeigt.

## Patentansprüche

1. Trägermatrix (1) für integrierte Halbleiter mit einem Rahmen (2), Leiterbahnstrukturen (3, 4) und zumindest einem Bondkanal (6), in dem Bondleads (5) oder Drähte zur Verbindung der Leiterbahnstrukturen (3, 4) mit dem integrierten Halbleiter angeordnet sind,
wobei entlang des Rands des Bondkanals (6) eine Rille (7,8) als Barriere zur Verhinderung des Fließens von flußfähigem Material aus dem Bondkanal (6) auf den Rahmen und/oder auf die Leiterbahnstrukturen (3, 4) angeordnet ist,
**dadurch gekennzeichnet, dass**
die Barriere (7, 8) einen Bereich mit einem Trennmittel aufweist, welches das flußfähige Material abweist.

2. Trägermatrix nach Anspruch 1,
**dadurch gekennzeichnet, dass**
die zumindest eine Barriere (7, 8) an allen Seiten des Bondkanals (6) angeordnet ist und diesen vollständig umgibt.

3. Trägermatrix nach Anspruch 1 oder 2,
**dadurch gekennzeichnet, dass** die zumindest eine Barriere (7, 8) auf dem Rahmen (2) und/oder auf den Bondleads (5) und/oder auf den Leiterbahnstrukturen (3, 4) angeordnet ist.

4. Trägermatrix nach einem der Ansprüche 1 bis 3,
**dadurch gekennzeichnet, dass**
die zumindest eine Barriere (7, 8) auf der den Bondleads (5) abgewandten Oberfläche des Rahmens (2) angeordnet ist.

5. Trägermatrix nach einem der Ansprüche 1 bis 4,
**dadurch gekennzeichnet, dass**
das flussfähige Material Silikon zur Ausbildung von Strukturen auf der Trägermatrix (1) ist.

6. Verfahren zur Herstellung einer Trägermatrix (1) für integrierte Halbleiter mit einem Rahmen (2), Leiterbahnstrukturen (3, 4) und zumindest einem Bondkanal (6), in dem Bondleads (5) zur Verbindung der Leiterbahnstrukturen (3, 4) mit dem integrierten Halbleiter angeordnet sind, mit folgendem Schritt:
- Einarbeiten zumindest einer Rille (7, 8) entlang des Rands des Bondkanals (6) zur Verhinderung des Fliessens von flussfähigem Material aus dem Bondkanal (6) auf den Rahmen (2) und/oder auf die Leiterbahnstrukturen (3, 4) sowie Aufbringen eines Trennmittels, welches das flußfähige Material abweist, auf einen Bereich der Rille (7, 8).

7. Verfahren nach Anspruch 6,
**dadurch gekennzeichnet, dass** es folgende Schritte aufweist:
- Aufbringen einer Lackmaske; und
- Ätzen von Rillen (7, 8) am Rand des Bondkanals (6).

8. Verfahren nach Anspruch 6,
**dadurch gekennzeichnet, dass** es folgenden Schritt aufweist:
- Prägen von Rillen (7, 8) am Rand des Bondkanals (6).

## Claims

1. Support matrix (1) for integrated semiconductors having a frame (2), conductor track structures (3, 4) and at least one bonding channel (6), in which bonding leads (5) or wires for connecting the conductor track structures (3, 4) to the integrated semiconductor are arranged,
there being arranged along the edge of the bonding channel (6) a groove (7, 8) as barrier for preventing the flow of flowable material from the bonding channel (6) onto the frame and/or the conductor track structures (3, 4),
**characterized in that**
the barrier (7, 8) has a region with a parting agent which repels the flowable material.

2. Support matrix according to Claim 1,
**characterized in that**
the at least one barrier (7, 8) is arranged on all sides of the bonding channel (6) and completely surrounds the latter.

3. Support matrix according to Claim 1 or 2,
**characterized in that**
the at least one barrier (7, 8) is arranged on the frame (2) and/or on the bonding leads (5) and/or on the conductor track structures (3, 4).

4. Support matrix according to one of Claims 1 to 3,
**characterized in that**
the at least one barrier (7, 8) is arranged on that surface of the frame (2) which is remote from the bonding leads (5).

5. Support matrix according to one of Claims 1 to 4,
**characterized in that**
the flowable material is silicone for forming structures on the support matrix (1).

6. Method for producing a support matrix (1) for integrated semiconductors having a frame (2), conductor track structures (3, 4) and at least one bonding channel (6) in which bonding leads (5) for connecting the conductor track structures (3, 4) to the integrated semiconductor are arranged, having the following step:
- incorporation of at least one groove (7, 8) along the edge of the bonding channel (6) for preventing the flow of flowable material from the bonding channel (6) onto the frame (2) and/or the conductor track structures (3, 4) and application of a parting agent which repels the flowable material to a region of the groove (7, 8).

7. Method according to Claim 6,
**characterized in that**
it has the following steps:
- application of a resist mask; and
- etching of grooves (7, 8) at the edge of the bonding channel (6).

8. Method according to Claim 6,
**characterized in that**
it has the following step:
- embossing of grooves (7, 8) at the edge of the bonding channel (6).

## Revendications

1. Matrice (1) support pour des semi-conducteurs intégrés comprenant un cadre (2), des structures (3, 4) de piste conductrice et au moins un canal (6) de liaison, dans lequel des conducteurs (5) de liaison ou des fils sont disposés pour relier les structures (3, 4) de piste conductrice au semi-conducteur intégré,
dans lequel il est disposé le long du bord du canal (6) de liaison une rainure (7, 8) servant de barrière pour empêcher l'écoulement des matières susceptibles de s'écouler du canal (6) de liaison sur le cadre et/ou sur les structures (3, 4) de piste conductrice,
**caractérisée en ce que**
la barrière (7, 8) a une partie ayant un agent de séparation qui repousse la matière susceptible de s'écouler.

2. Matrice support suivant la revendication 1,
**caractérisée en ce que**
la au moins une barrière (7, 8) est disposée de tous les côtés du canal (6) de liaison et l'entoure complètement.

3. Matrice support suivant la revendication 1 ou 2,
**caractérisée en ce que**
la au moins une barrière (7, 8) est disposée sur le cadre (2) et/ou sur le conducteur (5) de liaison et/ou sur les structures (3, 4) de piste conductrice.

4. Matrice support suivant l'une des revendications 1 à 3,
**caractérisée en ce que**
la au moins une barrière (7, 8) est disposée sur la surface du cadre (3), qui est éloignée du conducteur (5) de liaison.

5. Matrice support suivant l'une des revendications 1 à 4,
**caractérisée en ce que**
la matière susceptible de s'écouler est de la silicone pour la formation de structures sur la matrice (1) support.

6. Procédé de production d'une matrice (1) support pour des semi-conducteurs intégrés comprenant un cadre (2), des structures (3, 4) de piste conductrice et au moins un canal (6) de liaison dans lequel des conducteurs (5) de liaison sont disposés pour relier les structures (3, 4) de piste conductrice au semi-conducteur intégré, comprenant le stade suivant :
- on ménage au moins une rainure (7, 8) le long du bord du canal (6) de liaison pour empêcher l'écoulement de matière susceptible de s'écouler du canal (6) de liaison sur le cadre (2) et/ou sur les structures (3, 4) de piste conductrice, et on dépose sur une partie de la rainure (7, 8) un agent de séparation qui repousse la matière susceptible de s'écouler.

7. Procédé suivant la revendication 6,
**caractérisé en ce qu'**il a les stades suivants :
- dépôt d'un masque de vernis ; et
- production par attaque de rainures (7, 8) au bord du canal (6) de liaison.

8. Procédé suivant la revendication 6,
**caractérisé en ce qu'**il a des stades suivants :
- impression de rainures (7, 8) sur le bord du canal (6) de liaison.
